(19)

**Europäisches Patentamt**

**European Patent Office**

**Office européen des brevets**

(11) **EP 1 178 326 B1**

(12) **EUROPÄISCHE PATENTSCHRIFT**

(45) Veröffentlichungstag und Bekanntmachung des Hinweises auf die Patenterteilung:
**21.12.2005 Patentblatt 2005/51**

(51) Int Cl.$^7$: **G01R 33/09**

(21) Anmeldenummer: **00114447.6**

(22) Anmeldetag: **05.07.2000**

(54) **Verfahren und System zur Bestimmung der Orientierung von Magnetfeldern mit GMR-Sensoren**

Method and system to determine the orientation of a magnetic field with GMR sensors

Méthode et appareil pour déterminer l'orientation d'un champ magnétique avec des capteurs à magnétorésistance géante

(84) Benannte Vertragsstaaten:
**DE**

(43) Veröffentlichungstag der Anmeldung:
**06.02.2002 Patentblatt 2002/06**

(73) Patentinhaber: **Infineon Technologies AG
81669 München (DE)**

(72) Erfinder: **Maiwald, Hubert
94330 Salching (DE)**

(74) Vertreter: **Zimmermann & Partner
Postfach 33 09 20
80069 München (DE)**

(56) Entgegenhaltungen:
**EP-A- 0 807 827          DE-A- 19 613 402
US-A- 5 394 029**

## Beschreibung

Die Erfindung betrifft ein Verfahren zur Bestimmung der Orientierung eines äußeren magnetischen Feldes mit GMR-Sensoren. Die Erfindung betrifft weiterhin ein System mit GMR-Sensoren zur Bestimmung der Orientierung eines äußeren magnetischen Feldes.

Giant-Magneto-Resistors (GMR-Sensoren) sind erstmals in den 80-er Jahre hergestellt worden. Sie zeichnen sich durch ihre hohe Empfindlichkeit ihres elektrischen Leitungswiderstands auf die Orientierung von äußeren magnetische Feld aus.

GMR-Sensoren haben sich inzwischen als ideale Sensoren für berührungslose Positions- und Geschwindigkeitsvermessung magnetischer Objekte und für die berührungslose Messung von elektrischen Strömen bewährt. Aufgrund ihrer Robustheit gegenüber harschen Umwelteinflüssen werden sie oft in industrieller Umgebung oder im Bereich der Autoelektronik eingesetzt. Da der Widerstand der GMR-Sensoren von der Orientierung des äußeren magnetischen Feldes und, im weiten Bereich, nicht von der Stärke des magnetischen Feldes abhängt, kann der GMR-Sensor bequem zur Vermessung von Feldorientierungen verwendet werden, ohne daß der Abstand zwischen magnetischer Quelle und GMR-Sensor genau justiert sein muß.

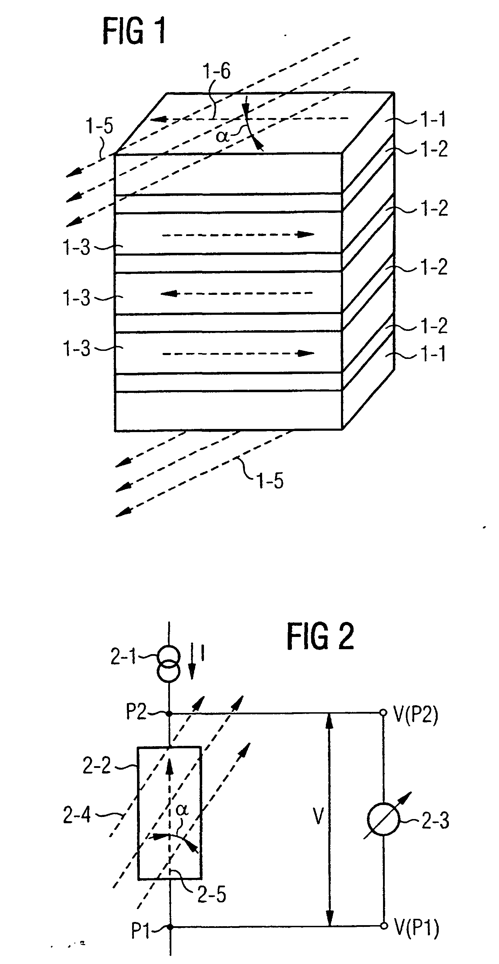

GMR-Sensoren gibt es in verschiedenen Ausführungsformen. Eine Ausführungsform ist in Fig. 1 beschrieben. Der dargestellte GMR-Sensor besteht hier aus sehr dünnen antiferromagnetischen Schichten, die abwechselnd mit sehr dünnen leitenden nicht-magnetischen Schichten 1-2, z.B. Kupfer, gestapelt sind. Die oberste und die unterste Schicht, d.h. die abdeckenden Schichten 1-1 des GMR-Sensors, bestehen aus einem weichen antiferromagnetischen Material, dessen magnetische Orientierung sich schon bei weichen äußeren magnetischen Feldern 1-5, die das Material durchdringen, nach diesen ausrichtet. Die anderen zwischen den leitenden nicht-magnetischen Schichten 1-2 liegenden Schichten sind harte antiferromagnetische Schichten 1-3, die z.B. aus Kobalt bestehen. In harte antiferromagnetische Schichten kann eine magnetische Richtung durch ein sehr starkes äußeres Feld eingeprägt werden, die sie später auch bei mittelstarken äußeren Feldern mit anderer Orientierung nicht mehr verändern. Die Orientierung der antiferromagnetischen harten Schichten 1-3 wird durch ein sehr starkes äußeres magnetisches Feld (>15 kA/m) einmalig eingeprägt und bestimmt die Orientierung des internen magnetischen Feldes des GMR-Sensors und damit die interne Orientierung des GMR-Sensors. Um die interne Orientierung der GMR-Sensoren doch zu ändern, muß ein äußeres magnetisches von mindestens der gleichen Stärke wieder angewandt werden.

Die Veränderung des elektrischen Widerstands durch eine Veränderung der Orientierung eines äußeren magnetischen (weichen) Feldes beruht darauf, daß der Widerstand, den Elektronen in magnetischen Materialien sehen, vom Winkel zwischen Spinrichtungen der Elektronen und der magnetischen Feldrichtung des Materials abhängt. Elektronen, die in der weichen elektronischen Schicht 1-1 die Spinrichtung des äußeren magnetischen Feldes 1-5 angenommen haben, sehen in den harten magnetischen Schichten 1-3 einen kleinen elektrischen Widerstand, wenn das interne magnetische Feld 1-6 des GMR-Sensors die gleiche magnetische Orientierung hat wie das äußere magnetische Feld 1-5. Der elektrische Gesamtwiderstand, R, eines GMR-Sensors setzt sich also aus einem Grundwiderstand, R0, und einem winkelabhängigen Widerstand R1 = ½ ΔR(1- cos α) zusammen, so daß gilt:

$$(1) \qquad R(T,\alpha) = R0(T) + \tfrac{1}{2}\, \Delta R(T) \times (1 - \cos \alpha),$$

wobei $\alpha$ der Winkel zwischen interner Orientierung 1-6 des GMR-Sensors und der Orientierung des äußeren Feldes 1-5 in der Ebene der abdeckenden Schichten 1-1 und $\Delta R(T)$ der maximale magnetoresistive Widerstand des GMR-Sensors ist.

Der in Gleichung (1) aufgenommene Parameter T weist darauf hin, daß der Widerstand nicht unerheblich von der Temperatur des GMR-Sensors abhängt. Typischerweise steigt bei steigender Temperatur der Grundwiderstand, während der magnetoresistive Widerstand mit der Temperatur sinkt. Typische Werte für die relative Temperaturdrift des Grundwiderstands R0(T) sind etwa 0.05%/K bis 0.2 %/K und für die relative Temperaturdrift des magnetoresistiven Widerstand ΔR(T) etwa -0.05 %/K bis -0.2 %/K. Diese Temperaturabhängigkeit bewirkt, daß eine Winkelzuordnung aus einem gemessenem Widerstand nicht eindeutig ist, wenn die Temperatur variiert und unbekannt ist.

Die Schichten der GMR-Sensoren sind typischerweise nur wenige nm dick und werden mit Präzisionstechniken, z.B. Sputter-Verfahren auf kleine Substrate aufgebracht. Die Strukturen der GMR-Sensoren werden mit lithographischen Methoden auf ein Substrat aufgebracht, so daß auch mehrere GMR-Sensoren auf kleinem Raum auf das Substrat aufgebracht werden können. Die elektrischen Verbindungen zwischen den GMR-Sensoren werden oft in Mäandern ausgelegt, um definierte Widerstände auf den Zuleitungen zu den GMR-Sensoren zu erzeugen.

Fig. 2 zeigt einen einfachen Meßaufbau mit einem GMR-Sensor nach Stand der Technik, mit dem die Orientierung eines äußeren magnetischen Feldes in der Ebene der GMR-Sensorschichten ohne Temperaturkompensation bestimmt werden kann. Der Meßaufbau besteht aus einer Stromquelle 2-1 mit einem eingestellten Strom I, einem GMR-Sensor 2-2 mit einer internen Orientierung 2-5, sowie einem Spannungsmeßgerät 2-3, das den Spannungsabfall V=V(P2)-V(P1) über den GMR-Sensor an den Punkten P1 und P2 abgreift. Sind aus vorausgegangenen Kalibrations-messungen R0 und $\Delta$R des GMR-Sensors bekannt, kann man aus dem gemessenen Spannungsabfall V mit Hilfe von (1) den Winkel $\alpha$ zwischen äußerem magnetischen Feld 2-4 und interner Orientierung 2-5 berechnen. Dieser einfache Meßaufbau hat jedoch die folgenden Nachteile:

1) die Winkelmessung ist nur im Bereich von 180 Grad eindeutig, nicht jedoch im vollen 360 Grad Bereich.
2) der magnetoresistive Effekt, $\Delta$R/R0, beträgt i.A. nur wenige Prozent, so daß die Spannungsmessung von einer großen Offsetspannung $V_{offs}$= R0 x I überlagert wird.
3) die Temperaturabhängigkeit der Parameter R0(T) und $\Delta$R(T) läßt bei unbekannter Temperatur des GMR-Sensors keine eindeutige Winkelbestimmung zu.

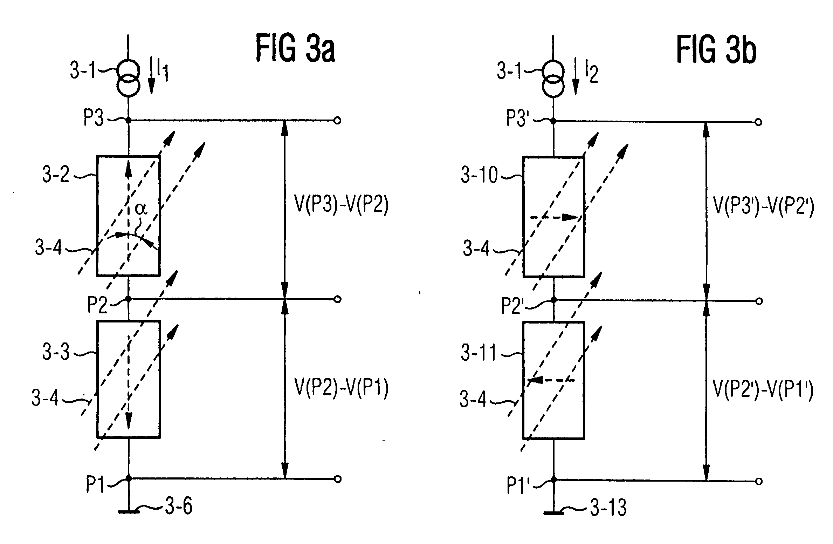

Eine wesentliche Verbesserung zur Vermeidung dieser Schwierigkeiten stellt die Verwendung zweier in Serie geschalteter baugleicher GMR-Sensoren mit zueinander antiparalleler interner Orientierung dar (Fig.3a und Fig.3b). Fig. 3a zeigt die beiden GMR-Sensoren 3-2 und 3-3 mit antiparalleler interner Orientierung und die Stromquelle 3-1 mit dem eingestellten Strom $I_1$, der über die Punkte P3, P2 und P2 zur Stromsenke 3-6 abfließt. Das auf die GMR-Sensoren einwirkende äußere magnetische Feld 3-4 bildet mit der internen magnetischen Orientierung des GMR-Sensors 3-2 den Winkel $\alpha$. Das äußere magnetische Feld soll für beide GMR-Sensoren gleich sein, was leicht erfüllt ist, wenn die räumliche Ausdehnung der beiden GMR-Sensoren zusammen klein ist im Vergleich zu der räumlichen Struktur des äußeren magnetischen Feldes 3-4.

Berücksichtigt man die Antiparallelität des GMR-Sensors 3-3 zum Referenz GMR-Sensor 3-2, so folgt aus (1) und Fig. 3a:

$$(2) \qquad V(P2)\text{-}V(P1) = (R0(T) + \tfrac{1}{2}\ \Delta R(T) \times (1 + \cos\ \alpha)) \times I_1$$

und

$$(3) \qquad V(P3)\text{-}V(P2) = (R0(T) + \tfrac{1}{2}\ \Delta R(T) \times (1 - \cos\ \alpha)) \times I_1$$

Die Differenz V1 der beiden Spannungen liefert dann:

$$(4) \qquad V1 = V(P2)\text{-}V(P1)\text{-}V(P3)+V(P2) = \Delta R(T) \times I_1 \times \cos\ \alpha$$

Die Verwendung von zwei in Serie geschalteten antiparallelen GMR-Sensoren kann somit dazu genutzt werden, durch Differenzbildung, den in Fig. 2 auftretenden großen (und temperaturabhängigen) Spannungsoffset R0(T) zu eliminieren. Die Differenzbildung kann dabei auf einfache Weise durch analoge elektronische Schaltungen realisiert werden, so daß auf kostengünstige Weise Zeitverzögerungen, die durch Digitalisierung und digitale Rechnungen aufgetreten, nicht vorkommen.

Um die Zweideutigkeit der Winkelbestimmung im 360 Grad Bereich zu beseitigen, bietet es sich an, eine zweite Schaltung von der Art wie in Fig. 3a parallel mit der gleichen Stromquelle anzusteuern. Eine solche zweite Schaltung ist in Fig. 3b gezeigt. Derartige elektronische Schaltungen mit GMR-Sensoren für die Messung der Orientierung eines magnetischen Feldes sind beispielsweise der Veröffentlichung DE 19619801 A1 zu entnehmen. Die zweite Schaltung weist GMR-Sensoren 3-10 und 3-11 mit der gleichen Bauart wie die erste Schaltung auf mit dem Unterschied, daß die internen Orientierungen der beiden GMR-Sensoren weitestgehend senkrecht zu den internen Orientierungen der GMR-Sensoren der ersten Schaltung stehen. Beide Schaltungen müssen dicht genug beieinander liegen, daß sie im wesentlichen das gleiche äußere magnetische 3-4 Feld sehen. Die Stromquelle 3-12 generiert den Strom $I_2$, der über die Punkte P3', P2'und P1' zur Stromsenke 3-13 hin abfließt. Die Spannungen V(P2')-V(P1') und V (P3')-V(P2'), die sich an den Punkten P1', P2'und P3' bilden, werden wie in Fig. 3a voneinander subtrahiert, so daß man analog zu Gl. (4) eine zweite winkelabhängige Spannungsmessung erhält mit

$$(5) \qquad V2 = V(P2')\text{-}V(P')\text{-}V(P3')+V(P2') = \Delta R(T) \times I_2 \times \sin\ \alpha.$$

Durch Division von (5) durch (4) erhält man eine temperaturunabhängige Beziehung zwischen dem Winkel $\alpha$ und den gemessenen Spannungen V1, V2, V1' und V2' :

$$(6) \qquad \alpha = \arctan \left( \Delta V' / \Delta V \right) = \arctan \left( (V1' - V2') / (V1 - V2) \right),$$

wobei der Einfachheit halber die Ströme $I_1$ und $I_2$ als gleich angenommen werden. Um die Eindeutigkeit im gesamten 360 Grad Winkelbestimmung zu gewährleisten, muß zusätzlich eine Schaltung eingesetzt werden, die anhand von V1, V2, V1' und V2' entscheidet, ob der Winkel sich in dem Bereich zwischen $-\pi/2 < \alpha < +\pi/2$ oder im Bereich $-\pi < \alpha < -\pi/2$ bzw. $+\pi/2 < \alpha < +\pi$ befindet.

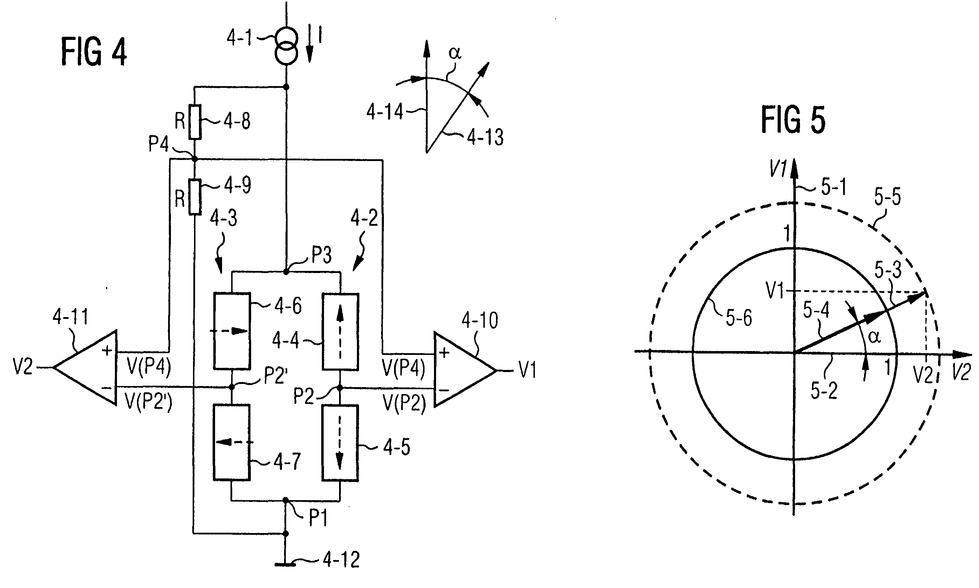

Fig. 4 zeigt eine solche elektronische Schaltung nach Stand der Technik unter Benutzung der in Fig. 3a und Fig. 3b beschriebenen GMR-Sensorschaltungen, die hier parallel zueinander geschaltet sind, d.h. P1=P1 'und P3=P3'. Der erste GMR-Sensor 4-4 und der in Serie geschaltete zweite GMR-Sensor 4-5, die beide zueinander antiparallele interne magnetischen Orientierung haben, bilden die erste Sensorteilschaltung 4-2; der erste GMR-Sensor 4-6 und der in Serie geschaltete zweite GMR-Sensor 4-7, die ebenfalls antiparallele interne magnetischen Orientierung haben, bilden die zweite Sensorteilschaltung 4-3. Die interne magnetische Orientierung der ersten Sensorteilschaltung 4-2, die durch die interne magnetische Orient des ersten GMR-Sensors 4-4 gegeben ist, ist zudem vertikal zu der internen magnetischen Orientierung der zweiten Sensorteilschaltung, die durch die interne magnetische Orientierung der ersten GMR-Sensors 4-4 gegeben ist. Die Orientierung des äußeren magnetischen Feldes 4-14 bildet mit der Orientierung des internen magnetischen Feldes des ersten GMR-Sensors 4-4 der ersten Sensorteilschaltung 4-2 den Winkel $\alpha$.

Beide Sensorteilschaltungen werden durch die gleiche Stromquelle 4-1 versorgt. Da die vier GMR-Sensoren im wesentlichen die gleichen Widerstandsparameter haben, teilt sich der Strom gleich auf die beiden Sensorteilschaltungen auf. Die beiden Operationsverstärker 4-10 und 4-11 bilden die Differenz zwischen den Signalen V(P2)-V(P4) und V2=V(P2')-V(P4), so daß das Ausgangssignal auf die vorhin beschriebene Weise offsetbereinigt ist:

$$(7) \qquad V1 = V(P2) - V(P4) = \tfrac{1}{2} \, \Delta R(T) \cos \alpha \times I/2$$

und

$$(8) \qquad V2 = V(P2') - V(P4) = \tfrac{1}{2} \, \Delta R(T) \sin \alpha \times I/2.$$

Das Verhältnis V2/V1 liefert eine eindeutige, temperaturunabhängige Beziehung zwischen Winkel $\alpha$ und den beiden gemessenen Ausgangssignalen:

$$(9) \qquad \alpha = \arctan (V2/V1) \, .$$

Ein Nachteil der in (6) und (9) angegebenen Beziehung ist jedoch, daß die Berechnung des arctan nicht durch einfache analoge Schaltung bewerkstelligt werden kann. Auch eine approximative Linearisierung ist nur in einem kleinen Wertebereich möglich. Die Berechnung erfordert daher i.A. eine Digitalisierung der beiden Ausgangssignale mit einer anschließenden Berechnung des arctan. Die Digitalisierung der beiden Werte ist jedoch sowohl kostenintensiv wie zeitaufwendig. Auch die digitale Berechnung des arctan macht eine Programmierung erforderlich, da diese Funktion in gängigen Mikrokontrollerschaltungen nicht implementiert ist. Auch das führt zu Zeitverzögerungen. Schließlich weist der tangens Unendlichkeiten im Wertebereich auf, die mit einem Rechner schlecht zu handhaben sind.

Der Erfindung liegt daher die Aufgabe zugrunde, ein Verfahren bereitzustellen, das die beschriebenen Probleme, insbesondere die temperaturabhängige Drift, welche die Ausgangssignale der beiden in Serie geschalteten antiparallelen GMR-Sensorpaare erfahren, auf einfache und schnelle Weise eliminiert oder zumindest reduziert. Der Erfindung liegt weiterhin die Aufgabe zugrunde, ein System mit GMR-Sensoren zur Bestimmung der Orientierung eines äußeren magnetischen Feldes bereitzustellen, das die Temperaturdrift der Ausgangssignale der beiden in Serie geschalteten antiparallelen GMR-Sensorpaare auf einfache und schnelle Weise herausrechnet.

Diese Aufgabe wird von dem Verfahren zur Bestimmung der Orientierung eines äußeren magnetischen Feldes gemäß des unabhängigen Patentanspruchs 1 gelöst. Weiterhin wird gemäß dem unabhängigen Patentanspruch 10 ein System mit GMR-Sensoren bereitgestellt, die eine temperaturunabhängige Messung der Orientierung eines äußeren magnetischen Feldes auf einfache Weise ermöglicht. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Bestimmung der Orientierung eines äußeren magnetischen Feldes mit GMR-Sensoren mit den folgenden Schritten bereitgestellt:

a) eine Sensorschaltung mit mindestens einer ersten und einer zweiten Sensorteilschaltung, die parallel zueinander geschaltet sind, wird bereitgestellt, wobei die erste und die zweite Sensorteilschaltung je mindestens einen ersten und einen zweiten GMR-Sensor aufweisen, die in Reihe geschaltet sind und die jeweils in entgegengesetzter interner magnetischer Orientierung angeordnet sind, wobei die interne magnetische Orientierung der GMR-Sensoren der ersten Sensorteilschaltung im wesentlichen senkrecht zur internen magnetischen Orientierung der GMR-Sensoren der zweiten Sensorteilschaltung ist;

b) in der ersten und der zweiten Sensorteilschaltung werden jeweils drei Sensorspannungen V(P1), V(P2), V(P3) an den Punkten P1, P2 und P3 abgegriffen, wobei P1 auf der Verbindungsleitung von Stromsenke zum zweitem GMR-Sensor, P2 auf der Verbindungslinie vom zweiten GMR-Sensor zum ersten GMR-Sensor und P3 auf der Verbindungslinie von erstem GMR-Sensor zur Stromversorgung liegt;

c) aus den drei Sensorspannungen der ersten Sensorteilschaltung wird durch eine erste Differenzschaltung eine Differenzspannung V1 erzeugt und aus den drei Sensorspannungen der zweiten Sensorteilschaltung wird durch eine zweite Differenzschaltung eine Differenzspannung V2 erzeugt;

d) ein Skalierungsfaktor wird mit Hilfe von V1 und V2 berechnet;

e) V1 und V2 werden mit dem Skalierungsfaktor so skaliert, daß aus ihnen die Orientierung des äußeren magnetischen Feldes bestimmt werden kann.

Das erfindungsgemäße Verfahren ermöglicht es, die Orientierung eines äußeren magnetischen Feldes, die durch den Winkel $\alpha$ gegeben ist, mit Hilfe von vier GMR-Sensoren zu bestimmen, wobei aufgrund der Skalierung das Resultat temperaturunabhängig ist und bei der Berechnung auf die Benutzung von arctan und/oder arccotan-Funktionen verzichtet werden kann. Die Benutzung von arctan- und/oder arccotan-Funktionen zur Berechnung des Winkels $\alpha$ erfordert eine Digitalisierung der Meßwerte und macht die Benutzung von programmierten Mikroprozessoren erforderlich, was kostenaufwendig und rechenintensiv ist. Das erfindungsgemäße Verfahren macht dagegen nur die Berechnung eines Skalierungsfaktors erforderlich, der bevorzugt die Quadratwurzel aus der Quadratsumme von V1 und V2 bzw. aus Näherungen an diese Quadratwurzel besteht. Weiterhin werden durch das erfindungsgemäße Verfahren negative Effekte der Exemplarstreuung der beteiligten GMR-Sensoren weitgehend kompensiert.

Die Skalierung mit dem Skalierungsfaktor kann bevorzugt mit analogen Schaltungen realisiert werden. Der Vorteil der analogen Prozessierung der Meßwerte liegt in der Einfachheit und in der überlegenen Schnelligkeit, mit der die Meßwerte aufbereitet werden, da Zeitverzögerungen durch die Analog/Digitalkonvertierung umgangen und die Rechenzeit durch die digitale Signalverarbeitung vermieden wird.

Die Orientierung eines äußeren magnetischen Feldes ist durch den Winkel $\alpha$ zwischen der Richtung des äußeren magnetischen Feldes und der Orientierung der Sensorschaltung gegeben. Die Orientierung der Sensorschaltung sei, per definitionem, im folgenden durch die interne Orientierung der ersten Sensorteilschaltung gegeben, wobei die interne Orientierung der ersten Sensorteilschaltung durch die interne magnetische Orientierung des ersten GMR-Sensors definiert ist. Die Orientierung der Sensorschaltung kann prinzipiell auch durch einen anderen GMR-Sensor definiert sein, was das erfindungsgemäße Verfahren nur unwesentlich ändert. Es ist lediglich am Schluß einer Messung das Hinzufügen einer Winkelkonstante zu dem gemessenen Wert erforderlich.

Das äußere magnetische Feld, dessen Orientierung zu bestimmen ist, sollte bevorzugt eine minimale Stärke aufweisen, damit der GMR-Sensor anspricht. Auf der anderen Seite darf die magnetische Stärke nicht zu groß sein, damit die interne magnetische Orientierung, die in jedem funktionstüchtigen GMR-Sensor eingeprägt ist, nicht verloren geht. Typische Werte für Felder, die mit GMR-Sensoren vermessen werden können liegen im Bereich von 5-10 kA/m. Da die GMR-Sensoren nur auf magnetische Feldkomponenten parallel zu den GMR-Schichtebenen empfindlich sind, bezieht sich diese Feldstärkeangabe auf die Feldkomponenten in dieser Ebene.

Weiterhin sollte die räumliche Struktur des äußeren magnetischen Feldes bevorzugt größer sein als der Bereich, in dem die vier GMR-Sensoren untergebracht sind. So ist gewährleistet, daß die vier GMR-Sensoren weitestgehend das gleiche magnetische äußere Feld sehen und die Ausgangsspannungen V1 und V2 genau skaliert werden können.

Es gibt verschiedene GMR-Sensorentypen, die für die Sensorschaltung in Frage kommen. Entscheidend für das erfindungsgemäße Verfahren ist, daß die GMR-Sensoren jeweils ein (hartes) internes magnetisches Feld mit einer fest eingeprägten magnetischen Orientierung aufweisen, wobei die Abhängigkeit des GMR-Sensorwiderstands von der Richtung des äußeren magnetischen Feldes weitgehend durch die Gleichung (1) beschrieben sein muß. Bevorzugt sind die Parameter R0(T) und $\Delta$R(T) der in der Sensorschaltung eingebauten GMR-Sensoren gleich oder zumindest sehr ähnlich, damit die Temperaturabhängigkeit durch das erfindungsgemäße Verfahren möglichst vollständig kompensiert werden kann. Bevorzugt sind die GMR-Sensoren einer Schaltung von der gleiche Bauart und bevorzugt auf einem gemeinsamen Substrat aufgebracht, damit der Verlauf der Parameter R0(T) und $\Delta$R(T) und die vorherrschende Temperatur T für alle GMR-Sensoren möglichst gleich sind. Weiterhin ist es Vorteil, wenn die GMR-Sensoren möglichst klein und dicht beieinander liegen, damit die Gesamtausdehnung des GMR-Sensorbereiches klein ist und die GMR-Sensoren dadurch möglichst die gleichen äußeren magnetischen Feldstärken sehen.

Die Sensorschaltung weist bevorzugt zwei Sensorteilschaltungen mit je mindestens zwei GMR-Sensoren auf. Vorstellbar sind aber auch mehr als zwei Sensorteilschaltungen für z.B. redundante Messungen. Eine Sensorteilschaltung weist jeweils mindestens einen ersten und einen zweiten GMR-Sensor auf, die in Serie miteinander geschaltet sind und die jeweils eine weitgehend antiparallele interne magnetische Orientierung zueinander haben. Eine Sensorteilschaltung kann aber auch mehr als die zwei antiparallel zueinander orientierten GMR-Sensoren aufweisen. z.B. kann jeder GMR-Sensor durch zwei oder mehr zueinander parallel orientierte GMR-Sensoren ersetzt sein. Bevorzugt weist eine Sensorteilschaltung auch serielle Widerstände auf, mit denen z.B. ein minimaler Gesamtwiderstand der Sensorteilschaltung erreicht werden kann. Dieser Widerstand wird bevorzugt durch die Ausgestaltung von mäanderförmigen Leitungen zwischen den GMR-Sensoren erzeugt.

Die erste und zweite Differenzschaltung erzeugen jeweils aus den drei Sensorspannungen V(P1), V(P2) und V(P3) der ersten und zweiten Sensorteilspannung eine Differenzspannung V1 und V2. Da die interne Orientierung der ersten Sensorteilschaltung weitgehend senkrecht zu der internen Orientierung der zweiten Sensorteilschaltung ist, erzeugt die erste Differenzschaltung eine Differenzspannung V1, die im wesentlichen die cosinus-Anteile der Orientierung des äußeren magnetischen Feldes darstellt, während die zweite Differenzschaltung eine Differenzspannung V2 erzeugt, die im wesentlichen die sinus-Anteile der Orientierung des äußeren magnetischen Feldes darstellt. Die senkrechte interne Orientierung der beiden Sensorteilschaltungen zueinander ermöglicht damit die erfindungsgemäße Berechnung der Skalierungsfaktoren. Unter senkrecht ist zu verstehen, daß der Winkel zwischen den internen Orientierungen der ersten Sensorteilschaltung und der zweiten Sensorteilschaltung sowohl etwa 90 Grad als auch etwa 270 Grad betragen kann.

Die Differenzspannungen V1 und/oder V2 werden bevorzugt zu einer Skalierungsschaltung geführt, die bevorzugt mit beiden Werten einen Skalierungsfaktoren berechnet und damit die Skalierung von V1 und V2 vornimmt. Aus den beiden skalierten V1 und V2 Werten kann die Orientierung des äußeren magnetischen Feldes temperaturunabhängig bestimmt werden.

Eine präzise Erfassung der Orientierung der äußeren magnetischen Felder mit Hilfe zweier erfindungsgemäßer Sensorteilschaltungen hängt auch von der Konstanz des Verhältnisses der Ströme durch die beiden Sensorteilschaltungen ab. Bevorzugt sind der Strom durch die erste Sensorteilschaltung und der Strom durch die zweite Sensorteilschaltung weitgehend gleich. Auf diese Weise werden die cos- und die sin-Anteile der Orientierung des äußeren magnetischen Feldes gleich gewichtet, so daß bei gleichen Differenzschaltungen die Skalierung korrekt durchgeführt werden kann. Bevorzugt wird die Gleichheit der Ströme dadurch verwirklicht, daß beide Sensorteilschaltungen die gleichen Widerstandskoeffizienten R0(T) und $\Delta$R(T) aufweisen und beide Sensorteilschaltungen durch eine gemeinsame Stromquelle oder Spannungsquelle versorgt werden, so daß auch bei variierender Temperatur aufgrund des Ohm'schen Gesetzes die Ströme beider Sensorteilschaltungen gleich sind.

Sind die beiden Ströme konstant aber nicht gleich, so muß eine anschließende kompensierende Wichtung der Cosinus-Anteile durchgeführt werden, die bevorzugt durch unterschiedliche Verstärkungsfaktoren der Differenzschaltungen realisiert wird.

Bevorzugt wird der Skalierungsfaktor durch die Quadratwurzel aus der Quadratsumme V1 und V2 berechnet. Dies ist der Wert, mit dem V1 und/oder V2 skaliert werden müssen, um temperaturunabhängig den Orientierungswinkel $\alpha$ des äußeren magnetischen Feldes zu erhalten. Bevorzugt werden sowohl V1 als auch V2 skaliert, um auf dem gesamten 360 Grad Bereich $\alpha$ eindeutig bestimmen zu können.

Bevorzugt erfolgt die Berechnung des Skalierungsfaktors durch eine analoge Schaltung, da dadurch Zeitverzögerung und Kosten durch die Digitalisierung der V1 und V2-Werte vermieden werden können. Auch die digitale Rechenzeit für die Berechnung der Wurzel aus der Quadratsumme von V1 und V2 fällt dadurch weg. Bevorzugt wird zunächst die Quadratur der V1 und V2 Werte parallel durch zwei analoge Multiplikatorschaltungen durchgeführt. Bevorzugt wird in einer weiteren Schaltung die Summe der beiden quadrierten Werte analog erzeugt. Bevorzugt wird schließlich auch die Wurzel der Quadratsumme von V1 und V2 analog erzeugt. Wird nur ein kleiner Winkelbereich für die Berechnung von $\alpha$ betrachtet oder ist nur eine begrenzte Genauigkeit der Winkelbestimmung erforderlich, so wird anstatt der Quadratwurzelfunktion nur eine analoge Näherung durchgeführt, bevorzugt auch ein konstanter Näherungswert, eine lineare Näherung und/oder Näherungen höherer Ordnung. Als eine lineare Näherung kann bevorzugt die Formel SQRT($x^2 + y^2$) = 0,96 x + 0.398 y mit x > y verwendet werden.

Bevorzugt kann die Wurzeloperation auch digital durchgeführt werden, was trotz Digitalisierung schneller und mit weniger Aufwand (programmierter Mikroprozessor etc.) geht als die Digitalisierung und Berechnung der arctan- oder arccotan-Funktionen wie es in Verfahren nach Stand der Technik zur Berechnung der Orientierung eines äußeren magnetischen Feldes durchgeführt wird.

Bevorzugt wird die Skalierung der V1 und/oder V2 Werte durch die Division der V1 und/oder V2-Werte durch den berechneten Skalierungsfaktor durchgeführt. Die Division erfolgt bevorzugt auf analogem Wege, um Zeitverzögerungen während der Digitalisierung und Schaltungsaufwand zu einzusparen. Die Division ist unproblematisch insbesondere dadurch, das der Skalierungsfaktor immer größer als 0 ist.

Die Bestimmung des Orientierungswinkels des äußeren magnetischen Feldes, $\alpha$, aus den skalierten V1 und/ oder V2-Werten kann auf verschiedenen Wegen erfolgen. In einer bevorzugten Version wird der arccos und/oder arcsin auf skalierten V1 und/oder V2 Werte angewandt, so daß gilt:

$$(10) \qquad \alpha = \arccos(V1) \text{ und/oder } \alpha = \arcsin(V2) .$$

Nachteilig ist, daß diese Funktionen einen größeren Schaltungsaufwand einschließlich programmiertem Mikroprozessor und Digitalisierung benötigen. Im Gegensatz zum Arccotangens und Arcustangens haben diese Funktionen jedoch keine Unendlichkeiten im Wertebereich.

In einer anderen bevorzugten Ausführung gibt es eine Tabelle, die jedem V1 und/oder V2-Wert einen Winkel $\alpha$ zuordnet. Diese Tabelle kann einer Kalibrierungsmessung entnommen sein oder bevorzugt auch einer einmaligen Berechnung. Da die skalierten V1 und V2-Werte temperaturunabhängig sind, wird nur eine Tabelle bei einer Temperatur benötigt.

Weiterhin wird ein erfindungsgemäßes System mit GMR-Sensoren zur Bestimmung der Orientierung eines äußeren magnetischen Feldes bereitgestellt, das dadurch gekennzeichnet ist, daß

a) das System eine Sensorschaltung mit einer ersten und einer zweiten Sensorteilschaltung aufweist, wobei die erste Sensorteilschaltung parallel zur zweiten Sensorteilspannung geschaltet ist und die erste und die zweite Sensorteilschaltung jeweils mindestens einen ersten und einen zweiten GMR-Sensor aufweisen, die in Reihe geschaltet sind und die jeweils in entgegengesetzter interner magnetischer Orientierung zueinander angeordnet sind, wobei die interne magnetische Orientierung der GMR-Sensoren der ersten Sensorteilschaltung im wesentlichen senkrecht zur internen magnetischen Orientierung der GMR-Sensoren der zweiten Sensorteilschaltung ist;

b) die erste und die zweite Sensorschaltung je drei Meßpunkte P1, P2 und P3 aufweisen, wobei P1 auf der Verbindungsleitung zwischen Stromsenke und zweitem GMR-Sensor liegt, P2 auf der Verbindungsleitung zwischen erstem und zweitem GMR-Sensor und P3 auf der Verbindungsleitung zwischen ersten GMR-Sensor und Stromversorgung, so daß an den Meßpunkten P1, P2 und P3 die drei Sensorspannungen V(P1), V(P2) und V(P3) abgegriffen werden können;

c) das System eine erste und eine zweite Differenzschaltung aufweist, wobei die erste Differenzschaltung aus den drei Sensorspannungen der ersten Sensorteilschaltung eine Differenzspannung V1 erzeugt, und die zweite Differenzschaltung aus den drei Sensorspannungen der zweiten Teilspannung eine Differenzspannung V2 erzeugt;

d) das System eine Skalierungsschaltung aufweist, die die Differenzspannung V1 und die Differenzspannung V2 ausliest und so skaliert, daß aus den skalierten Werten die Orientierung des äußeren magnetischen Feldes bestimmt werden kann.

Das erfindungsgemäße System mit Sensoren, Differenzschaltung und Skalierungsschaltung ermöglicht eine einfache Erfassung und Berechnung der Orientierung eines äußeren magnetischen Feldes, wobei die Berechnung vollständig oder weitgehend analog durchgeführt werden kann.

Die Einfachheit der temperaturkompensierten Berechnung der Orientierung eines äußeren magnetischen Feldes beruht auf der magnetisch antiparallelen Anordnung der GMR-Sensoren in den jeweiligen Sensorteilschaltungen und der magnetisch senkrechten Anordnung der Sensorteilschaltungen zueinander. Die Einfachheit der temperaturkompensierten Berechnung beruht weiterhin auf der Konstanz des Verhältnisses der Ströme, die durch die beiden Sensorteilschaltungen fließen. Bevorzugt sind der Strom durch die erste Sensorteilschaltung und der Strom durch die zweite Sensorteilschaltung gleich. Bevorzugt werden beide Ströme aus einer gemeinsamen Stromquelle gezogen, wobei der Gesamtwiderstand der ersten Sensorteilschaltung und der zweiten Sensorteilschaltung weitgehend gleich sind.

Bevorzugt sind die erste und die zweite Differenzschaltung gleich, insbesondere dann, wenn die Ströme durch beide Sensorteilschaltungen gleich sind. Bevorzugt berechnet die erste Differenzschaltung die Spannung V1 = V(P2)- ½ V(P3) und die zweite Differenzschaltung die Spannung V2 = V(P2') - ½ V(P3).

Bevorzugt weist die Skalierungsschaltung eine Schaltung zur Berechnung des Skalierungsfaktors auf, wobei die Schaltung zur Berechnung des Skalierungsfaktors bevorzugt die Quadratwurzel aus der Quadratsumme von V1 und V2 berechnet. Bevorzugt wird diese Berechnung analog durchgeführt, d.h. bevorzugt aus einer Schaltung, die erst die Quadrate von V1 und V2 bildet, diese Quadrate dann addiert und aus der Summe die Quadratwurzel zieht. Die Wurzelfunktion kann bevorzugt auch durch eine lineare und/oder quadratische Näherung durchgeführt werden.

Bevorzugt weist die Skalierungsschaltung weiterhin eine Schaltung zur Skalierung der V1 und/oder V2 Werte auf. Bevorzugt erfolgt diese Skalierung durch eine analoge Prozessierung, die V1 und/oder V2 jeweils durch den berechneten Skalierungsfaktor dividiert.

Bevorzugt weist die Skalierungsschaltung weiterhin eine Schaltung auf, welche die Zuordnung der skalierten V1 und/oder V2 Werte zu einem Orientierungswinkel des äußeren magnetischen Feldes durchführt. Diese Zuordnung geschieht bevorzugt durch tabellarische Zuordnung, die analog und/oder digital durchgeführt werden kann. Bevorzugt kann diese Zuordnung auch in einen ASIC integriert werden.

Bevorzugt werden weiterhin die an den beiden Sensorteilschaltungen anliegenden Ausgangsspannungen V1 und V2 analog verstärkt, bevor der Skalierungsfaktor berechnet und die Skalierung durchgeführt werden. Diese Maßnahme empfiehlt sich insbesondere bei kleinen Ausgangsspannungssignalen. Diese Maßnahme hat zudem keinen mindernden Einfluß auf die Skalierung hat.

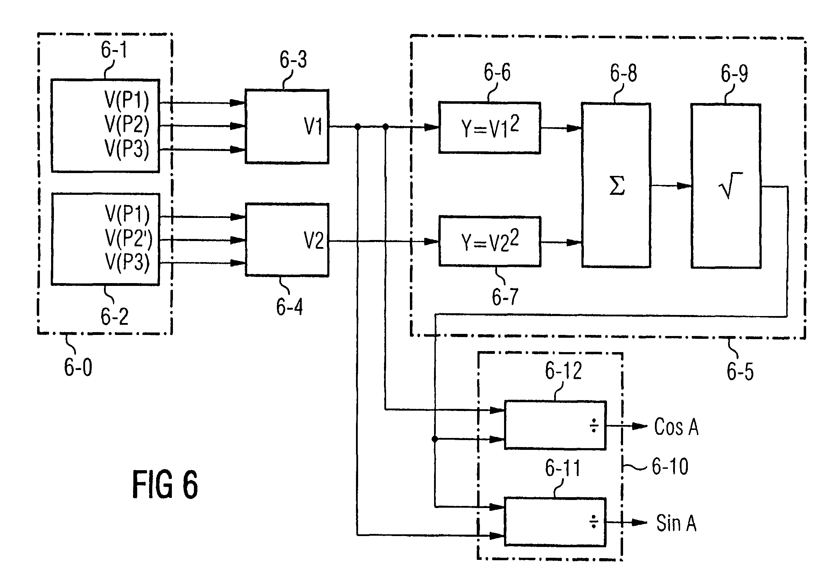

Die Erfindung wird nachfolgend anhand von Figur 5 und 6 näher dargestellt. Es zeigen:

Fig. 1          Schematischer Aufbau eines GMR-Sensors nach Stand der Technik.

Fig. 2          Grundschaltung mit einem GMR-Sensor zur Messung der Orientierung eines äußeren magnetischen Feldes nach Stand der Technik.

Fig. 3a - 3b    Sensorteilschaltungen mit je zwei GMRSensoren für die Sensorschaltung nach Stand der Technik.

Fig. 4          Sensorschaltung mit GMR-Sensoren und Differenzschaltung zur Bestimmung der Orientierung eines äußeren magnetischen Feldes nach Stand der Technik.

Fig. 5          Mathematische Darstellung des erfindungsgemäßen Verfahrens zur Bestimmung der Orientierung eines äußeren magnetischen Feldes.

Fig. 7          Erfindungsgemäße Ausführung der elektronischen Schaltung mit GMR-Sensoren zur Bestimmung der Orientierung eines äußeren magnetischen Feldes.

Fig.5 ist eine schematische Darstellung einer Ausführung des erfindungsgemäßen Verfahrens zur Bestimmung der Orientierung eines äußeren magnetischen Feldes, in dem durch Skalierung mit dem Skalierungsfaktor $\mathrm{SQRT}(V1^2+V2^2)$ die Temperaturabhängigkeit der Messung eliminiert werden kann und so temperaturunabhängig der Winkel eines äußeren magnetischen Feldes gemessen werden kann, ohne daß die arctan und/oder arccot Funktionen bemüht werden müssen.

In dem orthogonalen Koordinatensystem mit der V1-Achse 5-1 und V2-Achse 5-2 ist ein Vektor $V_m$ = (V1, V2) eingezeichnet, wobei die Vektorkomponenten V1 und V2 die Meßwerte aus einer Sensorschaltung sind wie sie in Fig. 4 dargestellt ist. Der gepunktete Kreis 5-5 repräsentiert dabei alle die Punkte (V1, V2), die die erfindungsgemäße Sensorschaltung bei einer festen Temperatur T1 durch Variieren der Orientierung eines äußeren magnetischen Feldes erreichen kann. Da die GMR-Sensoren in beiden Sensorteilschaltungen antiparallele interne magnetische Orientierung zueinander aufweisen und die Sensorteilschaltungen zueinander weitgehend senkrechte magnetische Orientierung haben, gilt:

$$V1 = \Delta R(T) \times I \times \cos \alpha$$

und

$$V2 = \Delta R(T) \times I \times \sin \alpha,$$

wobei $\alpha$ der Winkel zwischen der Orientierung des zu messenden äußeren magnetischen Feldes und der Orientierung des GMR-Sensors der ersten Sensorteilschaltung ist. Da die GMR-Sensoren die gleiche Temperaturabhängigkeit haben und durch beide Sensorteilschaltungen der gleiche Strom I fließt, liegen der Vektor $V_m$ und der Vektor mit der Orientierung des äußeren magnetischen Feldes aufeinander. Durch die Skalierung mit $\mathrm{SQRT}(V1^2 + V2^2)$ wird aus $V_m$ =(V1,V2) ein Einheitsvektor 5-4 erzeugt, der auf dem Einheitskreis 5-6 liegt:

$$V_{m0}=(V1/SQRT(V1^2+V2^2), V2/SQRT(V1^2 +V2^2)) = (\sin \alpha, \cos \alpha,)$$

Alle Vektoren (V1,V2) lassen sich durch diese Methode auf den Einheitskreis projizieren, so daß eine Tabelle mit einer Zuordnung von (V1,V2)-Einheitskreisvektoren zu dem Winkel $\alpha$ ausreicht, um jedem (V1, V2)-Vektor auch bei unbekannter Temperatur einen Winkel für das äußere magnetische Feld zuordnen zu können.

Fig. 6 zeigt schematisch den Aufbau einer erfindungsgemäßen Ausführung der elektronischen Schaltung mit GMR-Sensoren zur Bestimmung des Winkels $\alpha$ für die Orientierung eines äußeren magnetischen Feldes. Gezeigt ist die Sensorschaltung 6-0 mit den beiden Sensorteilschaltungen 6-1 und 6-2, wobei die Sensorschaltung 6-0 bevorzugt einen Aufbau wie in Fig. 4 hat. Die in Fig. 4 dargestellte Sensorschaltung zeichnet sich insbesondere durch die antiparallele interne magnetische Orientierung der ersten und zweiten GMR-Sensoren innerhalb einer Sensorteilschaltung sowie durch die vertikale magnetische Orientierung der beiden Sensorteilschaltungen zueinander aus. Weiterhin haben die vier GMR-Sensoren bevorzugt weitgehend den gleichen Grundwiderstand R0(T) und den gleichen magnetoresistiven Widerstand $\Delta$R(T) sowie die gleiche Temperaturabhängigkeit der beiden Parameter. Schließlich ist bevorzugt der Strom durch die erste Sensorteilschaltung 4-2 gleich groß wie der Strom durch die zweite Sensorteilschaltung 4-3. Der Strom fließt schließlich in der Stromsenke 4-12 wieder ab.

Die Differenzschaltung 6-3 der ersten Sensorteilschaltung 4-10 und Differenzschaltung 6-2 der zweiten Sensorteilschaltung 4-11 berechnen jeweils die Spannungsdifferenzen zwischen den Sensorspannungen V(P1),V(P2) und V(P3) bzw. V(P1),V(P2') und V(P3) wie in Fig. 4 gezeigt, so daß die Differenzspannungen V1 und V2 erzeugt werden:

$$V1= \tfrac{1}{2} \Delta R (T) \cos \alpha$$

$$V1= \tfrac{1}{2} \Delta R(T) \sin \alpha$$

wobei $\alpha$ der Winkel zwischen der Orientierung des äußeren magnetischen Feldes 4-13 und der internen Orientierung des ersten GMR-Sensors der ersten Sensorteilschaltung 4-14 ist.

Die Differenzspannungen V1 und V2 werden durch die in Fig.6 dargestellten Ausführung der erfindungsgemäßen elektrischen Skalierungsschaltung 6-5 weiterverarbeitet: V1 und V2 werden parallel zunächst in den analogen Schaltungen zur Quadrierung 6-6 und 6-7 quadriert und die quadrierten Werte in einem analogen Summierer 6-8 summiert. Anschließend wird aus der Quadratsumme in einer Schaltung zum Ziehen der Quadratwurzel 6-9 die Wurzel gezogen. Bevorzugt ist die Schaltung zum Ziehen der Quadratwurzel 6-9 eine analoge Schaltung. Das Ausgangssignal der Schaltung zur Berechnung des Skalierungsfaktors ist der Skalierungsfaktor $SQRT(V1^2+V2^2)$, der in die beiden Dividierer 6-10 hineingeführt wird. Gleichzeitig stehen an Eingängen der beiden Dividierer 6-10 und 6-12 jeweils ein unskalierter V1 und V2 Wert an, so daß eine Skalierung von V1 bzw. von V2 durchgeführt werden kann:

$$(11) \qquad V1_{sk} = V1 / SQRT(V1^2+V2^2) = \cos \alpha$$

und

$$(12) \qquad V2_{Sk} = V2 / SQRT(V1^2+V2^2 ) = \sin \alpha.$$

Die skalierten Werte sind somit temperaturunabhängig. Aus ihnen kann eindeutig der Winkel $\alpha$ bestimmt werden.

**Patentansprüche**

**1.** Verfahren zur Bestimmung der Orientierung eines äußeren magnetischen Feldes mit GMR-Sensoren mit den folgenden Schritten:

a) eine Sensorschaltung mit mindestens einer ersten und einer zweiten Sensorteilschaltung, die parallel zueinander geschaltet sind, wird bereitgestellt, wobei die erste und die zweite Sensorteilschaltung je mindestens einen ersten und einen zweiten GMR-Sensor aufweisen, die in Reihe geschaltet sind und die jeweils in entgegengesetzter interner magnetischer Orientierung angeordnet sind, wobei die interne magnetische Orientierung der GMR-Sensoren der ersten Sensorteilschaltung im wesentlichen senkrecht zur internen magnetischen Orientierung der GMR-Sensoren der zweiten Sensorteilschaltung ist;

b) in der ersten und der zweiten Sensorteilschaltung werden jeweils drei Sensorspannungen V(P1), V(P2), V(P3) an den Punkten P1, P2 und P3 abgegriffen, wobei P1 auf der Verbindungsleitung von Stromsenke zum zweitem GMR-Sensor, P2 auf der Verbindungslinie vom zweiten GMR-Sensor zum ersten GMR-Sensor und P3 auf der Verbindungslinie von erstem GMR-Sensor zur Stromversorgung liegt;

c) aus den drei Sensorspannungen der ersten Sensorteilschaltung wird durch eine erste Differenzschaltung eine Differenzspannung V1 erzeugt und aus den drei Sensorspannungen der zweiten Sensorteilschaltung wird durch eine zweite Differenzschaltung eine Differenzspannung V2 erzeugt;

d) ein Skalierungsfaktor wird mit Hilfe von V1 und V2 berechnet;

e) V1 und V2 werden mit dem Skalierungsfaktor so skaliert, daß aus ihnen die Orientierung des äußeren magnetischen Feldes bestimmt werden kann.

2. Verfahren nach Anspruch 1,
**dadurch gekennzeichnet, daß**
der Strom durch die erste Sensorteilschaltung und der Strom durch die zweite Sensorteilschaltung im wesentlichen gleich sind.

3. Verfahren nach einem der vorhergehenden Ansprüche,
**dadurch gekennzeichnet, daß**
die erste Differenzschaltung und die zweite Differenzschaltung gleich sind.

4. Verfahren nach einem der vorhergehenden Ansprüche,
**dadurch gekennzeichnet, daß**
der Skalierungsfaktor die Wurzel der Quadratsummen von V1 und V2 oder eine Näherung dazu ist.

5. Verfahren nach einem der vorhergehenden Ansprüche,
**dadurch gekennzeichnet, daß**
die Berechnung der Quadrate von V1 und/oder V2 durch eine analoge Schaltung durchgeführt wird.

6. Verfahren nach einem der vorhergehenden Ansprüche,
**dadurch gekennzeichnet, daß**
die Berechnung der Quadratsumme von V1 und V2 durch eine analoge Schaltung durchgeführt wird.

7. Verfahren nach einem der vorhergehenden Ansprüche,
**dadurch gekennzeichnet, daß**
die Berechnung der Wurzel der Quadratsumme von V1 und V2 durch eine analoge Schaltung genähert wird.

8. Verfahren nach einem der vorhergehenden Ansprüche,
**dadurch gekennzeichnet, daß**
die Skalierung der V1 und/oder V2 Werte durch Division der V1 und V2 Werte mit dem Skalierungsfaktor erfolgt.

9. Verfahren nach einem der vorhergehenden Ansprüche,
**dadurch gekennzeichnet, daß**
den skalierten V1- und/oder V2-Werten Orientierungswinkel des äußeren magnetischen Feldes zuordnet sind.

10. System mit GMR-Sensoren zur Bestimmung der Orientierung eines äußeren magnetischen Feldes
**dadurch gekennzeichnet, daß**

- das System eine Sensorschaltung mit einer ersten und einer zweiten Sensorteilschaltung aufweist, wobei die erste Sensorteilschaltung parallel zur zweiten Sensorteilschaltung geschaltet ist und die erste und die zweite Sensorteilschaltung jeweils mindestens einen ersten und einen zweiten GMR-Sensor aufweisen, die in Reihe geschaltet sind und die jeweils in entgegengesetzter interner magnetischer Orientierung zueinander angeordnet sind, wobei die interne magnetische Orientierung der GMR-Sensoren der ersten Sensorteilschaltung im wesentlichen senkrecht zur internen magnetischen Orientierung der GMR-Sensoren der zweiten Sensorteilschaltung ist;

- die erste und die zweite Sensorteilschaltung je drei Meßpunkte P1, P2 und P3 aufweisen, wobei P1 auf der Verbindungsleitung zwischen Stromsenke und zweitem GMR-Sensor liegt, P2 auf der Verbindungsleitung zwischen erstem und zweitem GMR-Sensor und P3 auf der Verbindungsleitung zwischen ersten GMR-Sensor und Stromversorgung, so daß an den Meßpunkten P1, P2 und P3 die drei Sensorspannungen V(P1), V(P2) und V(P3) abgegriffen werden können;

- das System eine erste und eine zweite Differenzschaltung aufweist, wobei die erste Differenzschaltung aus den drei Sensorspannungen der ersten Sensorteilschaltung eine Differenzspannung V1 erzeugt, und die zweite Differenzschaltung aus den drei Sensorspannungen der zweiten Sensorteilschaltung eine Differenzspannung V2 erzeugt;

- das System eine Skalierungsschaltung aufweist, die die Differenzspannung V1 und die Differenzspannung V2 ausliest und so skaliert, daß aus den skalierten Werten die Orientierung des äußeren magnetischen Feldes bestimmt werden kann.

**11.** System nach Anspruch 10,
**dadurch gekennzeichnet, daß**
der Strom durch die erste Sensorteilschaltung und der Strom durch die zweite Sensorteilschaltung im wesentlichen gleich sind.

**12.** System nach Anspruch 10 bis 11,
**dadurch gekennzeichnet, daß**
die erste und die zweite Differenzschaltung im wesentlichen gleich sind.

**13.** System g nach Anspruch 10 bis 12,
**dadurch gekennzeichnet, daß**
die Skalierungsschaltung eine Schaltung zur Berechnung des Skalierungsfaktors aufweist.

**14.** System nach Anspruch 13,
**dadurch gekennzeichnet, daß**
die Schaltung zur Berechnung des Skalierungsfaktors eine Schaltung zur Berechnung der Wurzel der Quadratsumme der V1 und V2 Werte oder eine Näherung davon aufweist.

**15.** System nach Anspruch 10 bis 14,
**dadurch gekennzeichnet, daß**
die Skalierungsschaltung eine Schaltung zur Skalierung der V1 und V2 Werte aufweist.

**16.** System nach Anspruch 15,
**dadurch gekennzeichnet, daß**
die Schaltung zur Skalierung der V1 und V2 Werte eine Schaltung aufweist, die die V1 und V2 Werte durch den Skalierungsfaktor dividiert.

**17.** System nach Anspruch 10 bis 16,
**dadurch gekennzeichnet, daß**
die elektronische Schaltung einen Algorithmus und/oder Daten aufweist, die den skalierten V1 und/oder V2 Werten einen Winkel zur Bestimmung der Orientierung des äußeren magnetischen Feldes zuordnet.

**18.** System nach Anspruch 10 bis 17,
**dadurch gekennzeichnet, daß**
die Skalierungsschaltung eine Schaltung aufweist, die die Zuordnung eines skalierten V1, V2 Wertepaars zu einem Orientierungswinkel des äußeren magnetischen Feldes durchführt.

**19.** System nach Anspruch 10 bis 18,
**dadurch gekennzeichnet, daß**
mindestens eine der Schaltungen der Skalierungsschaltung in einem ASIC integriert ist.

**20.** System nach Anspruch 10 bis 19,
**dadurch gekennzeichnet, daß**
die Spannungen V1 und/oder V2 vor elektronisch verstärkt werden.

**Claims**

1. Method for determining the orientation of an external magnetic field using GMR sensors, said method having the following steps:

   a) provision is made of a sensor circuit having at least a first and a second sensor subcircuit, which sensor subcircuits are connected in parallel with one another, the first and second sensor subcircuits each having at least a first and a second GMR sensor, which sensors are connected in series and are respectively arranged in the opposite internal magnetic orientation, and the internal magnetic orientation of the GMR sensors of the first sensor subcircuit essentially being perpendicular to the internal magnetic orientation of the GMR sensors of the second sensor subcircuit;

   b) three sensor voltages V(P1), V(P2), V(P3) are respectively tapped off at the points P1, P2 and P3 in the first and second sensor subcircuits, P1 being situated on the connecting line from the current sink to the second GMR sensor, P2 being situated on the connecting line from the second GMR sensor to the first GMR sensor and P3 being situated on the connecting line from the first GMR sensor to the current supply;

   c) a first differential circuit uses the three sensor voltages of the first sensor subcircuit to generate a differential voltage V1 and a second differential circuit uses the three sensor voltages of the second sensor subcircuit to generate a differential voltage V2;

   d) a scaling factor is calculated using V1 and V2; and

   e) the scaling factor is used to scale V1 and V2 in such a manner that they can be used to determine the orientation of the external magnetic field.

2. Method according to Claim 1,
   **characterized in that**
   the current through the first sensor subcircuit and the current through the second sensor subcircuit are essentially the same.

3. Method according to one of the preceding claims,
   **characterized in that**
   the first differential circuit and the second differential circuit are the same.

4. Method according to one of the preceding claims,
   **characterized in that**
   the scaling factor is the root of the sum of squares of V1 and V2 or an approximation thereto.

5. Method according to one of the preceding claims,
   **characterized in that**
   an analogue circuit calculates the squares of V1 and/or V2.

6. Method according to one of the preceding claims,
   **characterized in that**
   an analogue circuit calculates the sum of squares of V1 and V2.

7. Method according to one of the preceding claims,
   **characterized in that**
   an analogue circuit approximates the calculation of the root of the sum of squares of V1 and V2.

8. Method according to one of the preceding claims,
   **characterized in that**
   the V1 and/or V2 values are scaled by dividing the V1 and V2 values by the scaling factor.

9. Method according to one of the preceding claims,
   **characterized in that**
   orientation angles of the external magnetic field are assigned to the scaled V1 and/or V2 values.

**10.** System having GMR sensors for determining the orientation of an external magnetic field,
**characterized in that**

- the system has a sensor circuit having a first and a second sensor subcircuit, the first sensor subcircuit being connected in parallel with the second sensor subcircuit and the first and second sensor subcircuits each having at least a first and a second GMR sensor, which sensors are connected in series and are respectively arranged in the opposite internal magnetic orientation, and the internal magnetic orientation of the GMR sensors of the first sensor subcircuit essentially being perpendicular to the internal magnetic orientation of the GMR sensors of the second sensor subcircuit;

- the first and second sensor subcircuits each have three measurement points P1, P2 and P3, P1 being situated on the connecting line between the current sink and the second GMR sensor, P2 being situated on the connecting line between the first and second GMR sensors and P3 being situated on the connecting line between the first GMR sensor and the current supply, with the result that the three sensor voltages V(P1), V(P2) and V(P3) can be tapped off at the measurement points P1, P2 and P3;

- the system has a first and a second differential circuit, the first differential circuit using the three sensor voltages of the first sensor subcircuit to generate a differential voltage V1 and the second differential circuit using the three sensor voltages of the second sensor subcircuit to generate a differential voltage V2; and

- the system having a scaling circuit, which reads out the differential voltage V1 and the differential voltage V2 and scales them in such a manner that the scaled values can be used to determine the orientation of the external magnetic field.

**11.** System according to Claim 11,
**characterized in that**
the current through the first sensor subcircuit and the current through the second sensor subcircuit are essentially the same.

**12.** System according to Claims 11 to 12,
**characterized in that**
the first and second differential circuits are essentially the same.

**13.** System according to Claims 11 to 13,
**characterized in that**
the scaling circuit has a circuit for calculating the scaling factor.

**14.** System according to Claim 14,
**characterized in that**
the circuit for calculating the scaling factor has a circuit for calculating the root of the sum of squares of the V1 and V2 values or an approximation thereto.

**15.** System according to Claims 11 to 15,
**characterized in that**
the scaling circuit has a circuit for scaling the V1 and V2 values.

**16.** System according to Claim 15,
**characterized in that**
the circuit for scaling the V1 and V2 values has a circuit, which divides the V1 and V2 values by the scaling factor.

**17.** System according to Claims 11 to 16,
**characterized in that**
the electronic circuit has an algorithm and/or data, which assign(s) an angle for determining the orientation of the external magnetic field to the scaled V1 and/or V2 values.

**18.** System according to Claims 11 to 17,
**characterized in that**
the scaling circuit has a circuit which assigns a scaled pair of V1, V2 values to an orientation angle of the external magnetic field.

**19.** System according to Claims 11 to 18,
**characterized in that**
at least one of the circuits of the scaling circuit is integrated in an ASIC.

**20.** System according to Claims 11 to 19,
**characterized in that**
the voltages V1 and/or V2 are electronically amplified.

## Revendications

**1.** Procédé de détermination de l'orientation d'un champ magnétique extérieur par des capteurs GMR comprenant les stades suivants :

a) on se procure un circuit formant capteur ayant au moins un premier sous-circuit formant capteur et un deuxième sous-circuit formant capteur qui sont montés en parallèle, les premier et deuxième sous-circuits formant capteurs ayant respectivement au moins un premier et un deuxième capteur GMR qui sont montés en série et qui sont disposés respectivement suivant une orientation magnétique interne opposée, l'orientation magnétique interne des capteurs GMR du premier sous-circuit formant capteur étant sensiblement perpendiculaire à l'orientation magnétique interne des capteurs GMR du deuxième sous-circuit formant capteur ;
b) on prélève dans le premier et dans le deuxième sous-circuit formant capteurs respectivement trois tensions V(P1), V(P2), V(P3) de capteur aux points P1, P2, P3, P1 se trouvant sur la ligne reliant le puits de courant au deuxième capteur GMR, P2 sur la ligne reliant le deuxième capteur GMR au premier capteur GMR et P3 sur la ligne reliant le premier capteur GMR à l'alimentation en courant ;
c) à partir des trois tensions de capteur du premier sous-circuit de capteur, on produit une tension V1 de différence par un premier circuit de formation d'une différence, et à partir des trois tensions de capteur du deuxième sous-circuit de capteur, on produit une tension V2 de différence par un deuxième circuit de formation d'une différence ;
d) on calcule un facteur de mise à l'échelle à l'aide de V1 et V2 ;
e) on met à l'échelle V1 et V2 par le facteur de mise à l'échelle, de façon à pouvoir en déterminer l'orientation du champ magnétique extérieur.

**2.** Procédé suivant la revendication 1, **caractérisé en ce que** le courant passant dans le premier sous-circuit de capteur et le courant passant dans le deuxième sous-circuit de capteur sont sensiblement égaux.

**3.** Procédé suivant l'une des revendications précédentes, **caractérisé en ce que** le premier circuit de formation d'une différence et le deuxième circuit de formation d'une différence sont identiques.

**4.** Procédé suivant l'une des revendications précédentes, **caractérisé en ce que** le facteur de mise à l'échelle est la racine de la somme des carrés de V1 et V2 ou en est une approximation.

**5.** Procédé suivant l'une des revendications précédentes, **caractérisé en ce que** le calcul des carrés de V1 et/ou de V2 est effectué par un circuit analogique.

**6.** Procédé suivant l'une des revendications précédentes, **caractérisé en ce que** le calcul de la somme des carrés de V1 et de V2 est effectuée par un circuit analogique.

**7.** Procédé suivant l'une des revendications précédentes, **caractérisé en ce que** le calcul de la racine de la somme des carrés de V1 et V2 est approximée par un circuit analogique.

**8.** Procédé suivant l'une des revendications précédentes, **caractérisé en ce que** la mise à l'échelle des valeurs V1 et/ou V2 s'effectue par division des valeurs V1 et V2 par le facteur de mise à l'échelle.

**9.** Procédé suivant l'une des revendications précédentes, **caractérisé en ce que** des angles d'orientation du champ magnétique extérieur sont associés aux valeurs de V1 et/ou de V2 mises à l'échelle.

**10.** Système ayant des capteurs GMR de détermination de l'orientation d'un champ magnétique extérieur, **caractérisé en ce que**

- le système comporte un circuit de capteur ayant un premier sous-circuit de capteur et un deuxième sous-circuit de capteur, le premier sous-circuit de capteur étant monté en parallèle au deuxième sous-circuit de capteur et le premier et le deuxième sous-circuit de capteur ayant respectivement au moins un premier et un deuxième capteur GMR qui sont montés en série et qui sont disposés en orientation magnétique interne opposée l'un par rapport à l'autre, l'orientation magnétique interne des capteurs GMR du premier sous-circuit de capteur étant sensiblement perpendiculaire à l'orientation magnétique interne des capteurs GMR du deuxième sous-circuit de capteur ;
- le premier et le deuxième sous-circuit de capteur ont respectivement trois points R1, P2 et P3 de mesure, P1 se trouvant sur la ligne reliant un puits de courant et le deuxième capteur GMR, P2 sur la ligne reliant le premier et le deuxième capteur GMR et P3 sur la ligne reliant le premier capteur GMR et une alimentation en courant, de sorte que l'on peut prélever aux points P1, P2 et P3 de mesure les trois tensions V (P1), V (P2) et V(P3) de capteur ;
- le système a un premier et un deuxième circuit de formation d'une différence, le premier circuit de formation d'une différence produisant à partir des trois tensions de capteur du premier sous-circuit de capteur une tension V1 de différence, et le deuxième circuit de formation d'une différence produisant à partir des trois tensions de capteur du deuxième sous-circuit de capteur une tension V2 de différence ;
- le système a un circuit de mise à l'échelle qui lit la tension V1 de différence et la tension V2 de différence et les met à l'échelle, de façon à pouvoir déterminer l'orientation du champ magnétique extérieur à partir des valeurs mises à l'échelle.

**11.** Système suivant la revendication 10, **caractérisé en ce que** le courant passant dans le premier sous-circuit de capteur et le courant passant dans le deuxième sous-circuit de capteur sont sensiblement égaux.

**12.** Système suivant la revendication 10 ou 11, **caractérisé en ce que** le premier et le deuxième circuits de formation d'une différence sont sensiblement identiques.

**13.** Système suivant l'une des revendications 10 à 12, **caractérisé en ce que** le circuit de mise à l'échelle a un circuit de calcul du facteur de mise à l'échelle.

**14.** Système suivant la revendication 13, **caractérisé en ce que** le circuit de calcul de facteur de mise à l'échelle a un circuit de calcul de la racine de la somme des carrés des valeurs de V1 et V2 ou de leur approximation.

**15.** Système suivant l'une des revendications 10 à 14, **caractérisé en ce que** le circuit de mise à l'échelle a un circuit de mise à l'échelle des valeurs de V1 et V2.

**16.** Système suivant la revendication 15, **caractérisé en ce que** le circuit de mise à l'échelle des valeurs de V1 et V2 a un circuit qui divise les valeurs de V1 et V2 par le facteur de mise à l'échelle.

**17.** Système suivant l'une des revendications 10 à 16, **caractérisé en ce que** le circuit électronique comporte un algorithme et/ou des données qui associent aux valeurs mises à l'échelle V1 et/ou V2 un angle de détermination de l'orientation du champ magnétique extérieur.

**18.** Système suivant l'une des revendications 10 à 17, **caractérisé en ce que** le circuit de mise à l'échelle comporte un circuit qui effectue l'association d'une paire de valeurs V1, V2 mises à l'échelle à un angle d'orientation du champ magnétique extérieur.

**19.** Système suivant l'une des revendications 10 à 18, **caractérisé en ce qu'**au moins l'un des circuits du circuit de mise à l'échelle est intégré dans un ASIC.

**20.** Système suivant l'une des revendications 10 à 19, **caractérisé en ce que** les tensions V1 et/ou V2 sont préamplifiées électroniquement.

## FIG 1

## FIG 2

# FIG 3a

3-1

$\downarrow I_1$

P3

3-2

$\alpha$

3-4

$V(P3)-V(P2)$

P2

3-3

3-4

$V(P2)-V(P1)$

P1

3-6

# FIG 3b

3-1

$\downarrow I_2$

P3'

3-10

3-4

$V(P3')-V(P2')$

P2'

3-11

3-4

$V(P2')-V(P1')$

P1'

3-13

EP 1 178 326 B1

17

FIG 4

4-1

R 4-8

P4

R 4-9

4-3 4-2

P3

4-11 4-6 4-4

V2 V(P4) V(P4) V1

V(P2') P2' P2 V(P2)

4-7 4-5

P1

4-12

4-14 α 4-13

4-10

FIG 5

V1

5-1 5-5

1

5-3

V1 5-4

5-6 α

1 V2

5-2 V2

EP 1 178 326 B1

FIG 6

EP 1 178 326 B1